# FASCICULE DE BREVET EUROPEEN

(11) **EP 3 267 096 B1**
(45) Date de publication et mention de la délivrance du brevet: **30.09.2020**
(21) Numéro de dépôt: 17178800.3
(22) Date de dépôt: 29.06.2017
(51) Int. Cl.: F21S 41/141, H01L 33/08, H01L 33/58, F21S 41/43, F21Y 105/16, H01L 33/24

(54) **DISPOSITIF D'ECLAIRAGE ET/OU DE SIGNALISATION POUR VEHICULE AUTOMOBILE**
VORRICHTUNG ZUR BELEUCHTUNG UND/ODER SIGNALISIERUNG FÜR KRAFTFAHRZEUGE
LIGHTING AND/OR SIGNALLING DEVICE FOR A MOTOR VEHICLE

(30) Priorité: 05.07.2016 FR 1656386
(43) Date de publication de la demande: 10.01.2018
(73) Titulaire: Valeo Vision, 93012 Bobigny Cedex (FR)
(72) Inventeur: ALBOU, Pierre, 93012 BOBIGNY Cedex (FR); SANCHEZ, Vanesa, 93012 BOBIGNY Cedex (FR); COURCIER, Marine, 93012 BOBIGNY Cedex (FR)

(56) Documents cités:
- EP-A1- 2 587 134
- FR-A1- 3 031 238
- US-A1- 2014 166 974
- US-A1- 2015 377 453

## Description

L'invention a trait au domaine de l'éclairage et/ou de la signalisation, notamment pour véhicules automobiles. Elle concerne plus particulièrement une source de lumière et un dispositif lumineux, pour l'éclairage et/ou la signalisation d'un véhicule automobile, qui comprend une telle source de lumière et une optique de mise en forme des rayons lumineux émis par cette source.

Un véhicule automobile est équipé de projecteurs, ou phares, destinés à illuminer la route devant le véhicule, la nuit ou en cas de luminosité réduite. Ces projecteurs peuvent généralement être utilisés selon deux modes d'éclairage : un premier mode « feux de route » et un deuxième mode « feux de croisement ». Le mode « feux de route » permet d'éclairer fortement la route loin devant le véhicule. Le mode « feux de croisement » procure un éclairage plus limité de la route, mais offrant néanmoins une bonne visibilité, sans éblouir les autres usagers de la route.

Afin de ne pas éblouir les autres usagers de la route, on prévoit un faisceau Code, propre au mode « feux de croisement », qui présente une coupure droite formant un bord supérieur sensiblement horizontal, principalement située en dessous de la ligne d'horizon. Cette coupure peut présenter une forme étagée pour présenter une coupure basse dans la zone dans laquelle se situent théoriquement les autres usagers de la route et une partie haute permettant dans ce contexte de feux de croisement d'éclairer un peu plus loin la scène de route en dehors de cette zone. Ces coupures, qui génèrent un contraste fort entre la zone éclairée et le reste de la scène de route, peuvent notamment être réalisées par l'intermédiaire d'un cache disposé sur le trajet des rayons entre la source de lumière et l'optique de mise en forme.

D'autres types de faisceaux à coupure sont générés par l'utilisation des projecteurs modernes, et on a par exemple des faisceaux où la coupure est verticale, contrairement au faisceau Code évoqué précédemment où la coupure est horizontale. A titre d'exemple, on pourra parler de faisceau matriciel, dans lequel le faisceau est segmenté en bandes verticales générées respectivement par une pluralité de diodes électroluminescentes, l'extinction de telle ou telle source pour créer une bande sombre dans le faisceau étant piloté en fonction de la détection d'un véhicule dans la scène de route.

Dans chacun de ces cas, que ce soit pour que le faisceau Code soit réglementaire, ou pour que le conducteur ait une parfaite visibilité hors la zone sombre dans un faisceau matriciel, la coupure doit présenter un contraste suffisant, c'est-à-dire en d'autres termes que la coupure doit être très nette.

Toutefois, dans certaines zones de la scène de route illuminée par le faisceau d'éclairage du véhicule, il peut être préférable d'avoir des coupures plus floues afin d'avoir un faisceau bien homogène. A titre d'exemple, des lignes de contraste bien marquées dans le faisceau ou en bord de faisceau peuvent générer, en projection sur des obstacles tels que des arbres, des tunnels, ou des panneaux, des perturbations visuelles pour le conducteur. Ainsi, dans le but de proposer un faisceau d'éclairage efficace et plaisant pour le conducteur, le besoin quant à la netteté des coupures peut être différent d'une zone à l'autre d'un même faisceau.

On peut ainsi être amené à chercher une netteté variable des coupures, avec par exemple une coupure nette dans l'axe de la trajectoire du véhicule, c'est-à-dire la direction de conduite, et une coupure plus floue sur les côtés.

Le brevet FR2986621 divulgue une solution technique selon laquelle la lentille est modifiée pour présenter des motifs perpendiculaires les uns par rapport aux autres, et qui permettent d'avoir une netteté différente entre la coupure horizontale et les coupures verticales. On comprend que l'application de motifs sur la lentille est complexe à mettre en œuvre et donc coûteuse. La demande US 2015/0377453 décrit une source de lumière connue.

La présente invention s'inscrit dans ce contexte, alors que les sources de lumière utilisées dans ces projecteurs sont de plus en plus fréquemment constituées par des diodes électroluminescentes, notamment pour des avantages d'encombrement et d'autonomie par rapport à des sources de lumière classiques. L'utilisation de diodes électroluminescentes dans les modules d'éclairage et/ou de signalisation a permis en outre aux acteurs du marché (constructeurs automobiles et concepteurs de dispositifs d'éclairage et/ou de signalisation) d'apporter une touche créative à la conception de ces dispositifs, notamment par l'utilisation d'un nombre toujours plus grand de ces diodes électroluminescentes pour réaliser des effets optiques. Un des inconvénients à l'utilisation de ces diodes est leur coût de revient.

Dans ce double contexte, l'invention vise à proposer un dispositif lumineux qui permet un contrôle de la netteté des différentes coupures formées dans le faisceau lumineux qu'il participe à projeter, en s'inscrivant dans un contexte économique où les coûts de revient des sources de lumière sont cherchés le plus bas possible, tout en maintenant ou en augmentant les capacités d'éclairage de ces sources de lumière et notamment en améliorant la gestion de l'intensité lumineuse au niveau des coupures de faisceau.

L'invention a pour objet une source de lumière à semi-conducteur ainsi qu'un dispositif lumineux comprenant une telle source et une optique de mise en forme des rayons lumineux émis par cette source. Notamment, la source de lumière faisant l'objet de l'invention comprend un support, qui peut notamment être un substrat, une pluralité d'éléments émetteurs de lumière, s'étendant respectivement depuis le substrat, ces éléments émetteurs de lumière pouvant notamment être qui peuvent notamment être des bâtonnets électroluminescents à semiconducteurs, de dimensions submillimétriques. La source de lumière comporte en outre une pluralité de parois de séparation s'étendant également depuis le support en étant agencées entre lesdits éléments émetteurs de lumière de manière à définir des groupes de ces éléments et de telle sorte qu'au moins deux parois de séparation présentent une hauteur différente et qu'au moins une paroi de séparation présente une section sensiblement trapézoïdale

Par le terme hauteur, que ce soit ici des parois de séparation ou par la suite des éléments émetteurs de lumière, on définit la dimension d'extension de ces éléments depuis le support, sensiblement perpendiculairement à la surface supérieure de celui-ci, c'est-à-dire la surface dont émergent les parois de séparation et les éléments émetteurs de lumière.

Par ailleurs, par optique de mise en forme, on entend qu'au moins un des rayons émis par la source lumineuse est dévié par l'optique de mise en forme, c'est-à-dire que la direction d'entrée de ce au moins un rayon lumineux dans l'optique de mise en forme est différente de la direction de sortie du rayon lumineux de l'optique de mise en forme. L'optique de mise en forme comprend au moins un élément optique tel qu'une ou plusieurs lentilles, un ou plusieurs réflecteurs, un ou plusieurs guides de lumière ou une combinaison de ces possibilités.

L'optique de mise en forme peut comprendre une optique de projection de la lumière émise par la source de lumière à semi-conducteur. Cette optique de projection crée une image réelle, et éventuellement anamorphosée, d'une partie du dispositif, par exemple la source elle-même ou un cache, ou d'une image intermédiaire de la source, à distance (finie ou infinie) très grande devant les dimensions du dispositif (d'un rapport de l'ordre d'au moins 30, de préférence 100) du dispositif. Cette optique de projection peut consister en un ou plusieurs réflecteurs, ou bien en une ou plusieurs lentilles, ou un ou plusieurs guides de lumière ou encore en une combinaison de ces possibilités.

L'optique de mise en forme pourra être agencée de manière à ce que la source de lumière ne soit pas située sur le plan focal objet de l'optique de mise en forme.

Ceci permet notamment de projeter une image qui parait continue, en imagerie directe, sans nécessiter de prévoir un système de projection devant modifier l'image source avant d'être projetée. Ceci est particulièrement intéressant pour simplifier le dispositif proposé, notamment lorsqu'une ou plusieurs parois de séparation sont disposées en saillie du substrat pour participer à la pixellisation optique du faisceau règlementaire projeté.

Les au moins deux parois de hauteur différente définissent avantageusement un même groupe de bâtonnets. Par cette notion de parois définissant un même groupe de bâtonnets, on comprend que l'on considère au moins deux parois qui forment chacune une paroi délimitant un même premier groupe de bâtonnets indépendant d'un deuxième groupe de bâtonnets. Et ceci, que ces deux parois soient sensiblement parallèles ou qu'elles soient contigües, et quel que soit le nombre de parois qui participent à délimiter ce premier groupe de bâtonnets.

Ainsi, on applique au domaine automobile une technologie consistant à réaliser la zone émettrice de lumière par une pluralité de bâtonnets électroluminescents que l'on fait croître sur un substrat, pour réaliser une topologie en trois dimensions. On comprend que cette topologie en trois dimensions présente l'avantage de multiplier la surface d'émission lumineuse par rapport aux diodes électroluminescentes connues jusque-là dans le domaine de l'automobile, à savoir des diodes sensiblement planes. De la sorte, il est possible de fournir à moindre coût de revient une lumière blanche très lumineuse

On peut prévoir que les bâtonnets électroluminescents sont activables sélectivement, et qu'au moins deux groupes de bâtonnets électroluminescents de la source de lumière soient agencés pour être allumés de manière sélective, étant entendu qu'on entend par cela qu'un ou plusieurs bâtonnets de la source de lumière peuvent être pilotés pour jouer sur leur intensité lumineuse. On prévoit un système de contrôle de l'allumage distinct de ces bâtonnets, étant entendu qu'on entend principalement par cela que les bâtonnets peuvent être allumés ou éteints distinctivement les uns des autres, simultanément ou non.

On permet la réalisation d'une lumière pixellisée, qui peut évoluer en fonction des conditions de circulation par l'extinction et l'allumage de l'un ou l'autre des bâtonnets formant la source de lumière. En d'autres termes, l'application d'une source de lumière à semi-conducteur, comportant des bâtonnets électroluminescents de dimensions submillimétriques, dans un projecteur de véhicule automobile permet une mise en place simplifiée de systèmes d'éclairage adaptatifs, dans lesquels on peut souhaiter former des faisceaux matriciels dont une partie peut être éteinte pour par exemple ne pas éblouir un autre usager de la route.

La présence de parois de séparation au voisinage direct des bâtonnets électroluminescents permet de réaliser une coupure dans le faisceau en bloquant certains des rayons émis par ces bâtonnets, et on comprend que la netteté de la coupure est relative à la hauteur de la paroi de séparation correspondante et à la position du sommet de ces parois par rapport au foyer de l'optique de projection : plus la face d'extrémité libre de la paroi de séparation, dont la distance par rapport au support définit la hauteur de cette paroi, est proche de la surface focale objet de l'optique de mise en forme, plus la coupure est nette.

Les bâtonnets électroluminescents et les parois de séparation peuvent s'étendre à partir d'un même substrat, et ils peuvent notamment être formés directement sur ce substrat. On peut prévoir que le substrat soit à base de silicium ou de carbure de silicium. On comprend que le substrat est à base de silicium dès lors qu'il comporte majoritairement du silicium, par exemple au moins 50% et dans la pratique environ 99%.

Selon une première série de caractéristiques propres à la constitution des parois de séparation et à la disposition de ces parois de séparation sur le substrat, on pourra prévoir que, chaque caractéristique pouvant être prise seule ou en combinaison avec les autres :
- les deux parois de séparation, définissant un même groupe de bâtonnets et dont les hauteurs sont différentes, s'étendent sensiblement perpendiculairement l'une par rapport à l'autre ;
- une première série de parois de séparation, sensiblement parallèles entre elles, s'étend depuis le substrat selon une première direction, en présentant une hauteur moyenne supérieure à la hauteur moyenne d'une deuxième série de parois de séparation, sensiblement parallèles entre elles et s'étendant selon une deuxième direction, notamment sensiblement perpendiculairement à la première direction. Notamment dans le cas d'application d'une source de lumière avec des bâtonnets électroluminescents agencés en une matrice à deux dimensions, on pourra prévoir une première série de parois de séparation dans laquelle chacune des parois de séparation est perpendiculaire aux parois de séparation de la deuxième série ;
- au moins les parois de séparation de la première ou de la deuxième série présentent une hauteur évolutive, allant en décroissant du centre de la source vers au moins un bord de la source ;

Selon une deuxième série de caractéristiques propres à la constitution des bâtonnets électroluminescents et à la disposition de ces bâtonnets électroluminescents sur le substrat, on pourra prévoir que, chaque caractéristique pouvant être prise seule ou en combinaison avec les autres :
- chaque bâtonnet présente une forme générale cylindrique, notamment de section polygonale ; on pourra prévoir que chaque bâtonnet ait la même forme générale, et notamment une forme hexagonale ;
- les bâtonnets sont chacun délimités par une face terminale et par une paroi circonférentielle qui s'étend le long d'un axe longitudinal du bâtonnet définissant sa hauteur, la lumière étant émise au moins à partir de la paroi circonférentielle ; cette lumière pourrait également être émise par la face terminale ;
- chaque bâtonnet peut présenter une face terminale qui est sensiblement perpendiculaire à la paroi circonférentielle, et dans différentes variantes, on peut prévoir que cette face terminale est sensiblement plane ou bombée, ou pointue, en son centre ;
- les bâtonnets sont agencés en matrice à deux dimensions, que cette matrice soit régulière, avec un espacement constant entre deux bâtonnets successifs d'un alignement donné, ou que les bâtonnets soient disposés en quinconce ;
- la hauteur d'un bâtonnet est comprise entre 1 et 10 micromètres ;
- la plus grande dimension de la face terminale est inférieure à 2 micromètres ;
- la distance qui sépare deux bâtonnets immédiatement adjacents est au minimum égale à 2 micromètres, et au maximum égale à 100 micromètres.

Selon d'autres caractéristiques, on pourra prévoir que la source de lumière à semi-conducteur comprenant une pluralité de bâtonnets électroluminescents de dimensions submillimétriques comporte en outre une couche d'un matériau polymère formant un encapsulant dans lequel les bâtonnets et les parois de séparation sont au moins partiellement noyés ; un tel encapsulant est déposé sur le substrat en recouvrement des bâtonnets et des parois de séparation, et il est avantageux que l'encapsulant s'étende au moins jusqu'à recouvrir le bâtonnet le plus haut. Ce matériau polymère peut être à base de silicone, étant entendu que le matériau polymère est à base de silicone dès lors qu'il comporte majoritairement du silicone, par exemple au moins 50% et dans la pratique environ 99%. La couche de matériau polymère peut comprendre un luminophore ou une pluralité de luminophores excités par la lumière générée par au moins un de la pluralité de bâtonnets. On entend par luminophore, ou convertisseur de lumière, la présence d'au moins un matériau luminescent conçu pour absorber au moins une partie d'au moins une lumière d'excitation émise par une source de lumière et pour convertir au moins une partie de ladite lumière d'excitation absorbée en une lumière d'émission ayant une longueur d'onde différente de celle de la lumière d'excitation. Ce luminophore, ou cette pluralité de luminophores, peut être au moins partiellement noyé dans le polymère ou bien disposé en surface de la couche de matériau polymère. A titre d'exemple, les rayons émis par les bâtonnets peuvent être de longueur d'onde correspondante à la couleur bleue et sont susceptibles d'être pour certains d'entre eux convertis en des rayons de longueur d'onde correspondante à la couleur jaune, de sorte que la synthèse additive du bleu non converti et du jaune forme un faisceau blanc en sortie de la couche de matériau polymère. A cette fin on pourra utiliser seul ou en combinaison par exemple les matériaux luminescents suivants : Y₃Al₅O₁₂:Ce³⁺ (YAG), (Sr,Ba)₂SiO₄:Eu²⁺, Caₓ(Si,Al)₁₂(O,N)₁₆:Eu²⁺.

Selon différentes caractéristiques particulières de l'invention, propres au dispositif comportant d'une part une source de lumière tel que présentée ci-dessus et d'autre part une optique de mise en forme, on peut prévoir que :
- la hauteur différente d'au moins deux parois de séparation définissant un même groupe de bâtonnets permet d'obtenir un faisceau lumineux présentant des coupures à netteté variable ;
- une première série de parois de séparation s'étend sensiblement verticalement en regard de l'optique de mise en forme tandis qu'une deuxième série de parois de séparation s'étend sensiblement horizontalement en regard de l'optique de mise en forme, la première série étant comme précédemment de hauteur moyenne plus haute que la hauteur moyenne de la deuxième série.
- l'encapsulant recouvre l'intégralité des parois de séparation, la surface focale de l'optique de mise en forme étant confondue avec une surface d'extrémité de l'encapsulant ;
- l'encapsulant recouvre partiellement une ou plusieurs parois de séparation, la surface focale de l'optique de mise en forme étant ajustée sur la face d'extrémité de la paroi de séparation la plus haute ;
- le dispositif lumineux comprend une source de lumière qui assure la génération de rayons de lumière qui forment au moins un faisceau lumineux réglementaire pour véhicule automobile. Par faisceau réglementaire, on entend un faisceau qui respecte une des grilles photométriques illustrée dans les figures.

Le dispositif peut prendre aussi bien place dans un projecteur avant que dans un feu arrière de véhicule automobile.

D'autres caractéristiques et avantages de la présente invention apparaitront plus clairement à l'aide de la description et des dessins parmi lesquels :
- la figure 1 est une vue en coupe d'un dispositif d'éclairage et/ou de signalisation selon l'invention, dans lequel on a illustré des rayons lumineux émis par une source de lumière à semi-conducteur selon l'invention en direction d'une optique de mise en forme ;
- la figure 2 est une représentation schématique en perspective de la source de lumière à semi-conducteur de la figure 1, dans laquelle on a rendu visible en coupe une rangée de bâtonnets électroluminescents, et dans laquelle on a représenté un exemple de réalisation de deux parois de séparation de hauteurs différentes définissant un premier groupe de bâtonnets ;
- la figure 3 est une vue en coupe d'un détail d'un mode de réalisation particulier d'une source de lumière à semi-conducteur selon l'invention, dans lequel deux bâtonnets électroluminescents et une paroi de séparation s'étendent en saillie d'un substrat, lesdits bâtonnets électroluminescents et la paroi étant encapsulés dans une couche protectrice ;

- la figure 4 est une représentation schématique en perspective d'un agencement de bâtonnets et de parois de séparation en saillie d'un substrat d'une source de lumière à semi-conducteur selon l'invention ;
- la figure 5 est une représentation schématique du concept de hauteurs variables des parois de séparation pour l'obtention d'un contraste plus ou moins net des faisceaux émis par différents bâtonnets électroluminescents ;
- la figure 6 est une représentation schématique du concept illustré sur la figure 5, avec de parois de séparation présentant des formes trapézoïdales et une pluralité de bâtonnets agencés entre deux parois de séparation, l'ensemble étant illustré dans un mode de réalisation particulier où une couche de matériau forme un encapsulant recouvrant intégralement les bâtonnets et les parois ;
- la figure 7 est une représentation sensiblement similaire à celle de la figure 6, illustrant ici une variante sur la hauteur d'une couche de matériau formant un encapsulant des bâtonnets et des parois de séparation, ici seulement partiellement noyées contrairement à ce qui est illustré sur la figure 6 ;
- les figures 8 à 10 illustrent des exemples de réalisation des parois de séparation, de section sensiblement rectangulaire (figure 8), trapézoïdale (figure 9), ou avec au moins une face présentant un profil de parabole (figure 10) ;
- la figure 11 illustre un exemple d'agencement de parois de séparation, avec une décroissance de la hauteur de ces parois depuis le centre de la source de lumière vers les bords ; et
- les figures 12 et 13 illustrent des représentations schématiques, en vue de dessus d'une source de lumière, de l'agencement des parois de séparation et de leurs hauteurs respectives dans le cadre de l'obtention en sortie du dispositif d'éclairage associé d'un premier type de faisceaux (figure 12) ou d'un deuxième type de faisceaux (figure 13).

Un dispositif d'éclairage et/ou de signalisation d'un véhicule automobile comporte une source de lumière 1, notamment logée dans un boîtier 2 fermé par une glace 4 et qui définit un volume interne de réception de ce dispositif émetteur. La source de lumière est associée à une optique de mise en forme 6 d'une partie au moins une partie des rayons lumineux émis par la source à semi-conducteur. Tel que cela a pu être précisé précédemment, l'optique de mise en forme change une direction d'au moins une partie des rayons lumineux émis par la source.

La source de lumière 1 est une source à semi-conducteur, comprenant des éléments émetteurs de lumière, consistant notamment dans le cas illustré, et tel que cela va être décrit par la suite à titre d'exemple, en des bâtonnets électroluminescents de dimensions submillimétriques, c'est-à-dire des sources à semi-conducteur en trois dimensions tel que cela sera exposé ci-après, contrairement aux sources classiques en deux dimensions, assimilées à des sources sensiblement planes du fait de leur épaisseur de l'ordre de quelques nanomètres alors qu'une source à bâtonnets électroluminescents présente une hauteur au moins égale au micromètre.

La source de lumière 1 comprend une pluralité de bâtonnets électroluminescents 8 de dimensions submillimétriques, que l'on appellera par la suite bâtonnet électroluminescents. Ces bâtonnets électroluminescents 8 prennent naissance sur un même support, et notamment un substrat 10 dans le cas d'application des bâtonnets électroluminescents. Chaque bâtonnet électroluminescent, ici formé par utilisation de nitrure de gallium (GaN), s'étend perpendiculairement, ou sensiblement perpendiculairement, en saillie du substrat, ici réalisé à base de silicium, d'autres matériaux comme du carbure de silicium pouvant être utilisés sans sortir du contexte de l'invention. A titre d'exemple, les bâtonnets électroluminescents pourraient être réalisés à partir d'un alliage de nitrure d'aluminium et de nitrure de gallium (AlGaN), ou à partir d'un alliage d'aluminium, d'indium et de gallium (Al1nGaN).

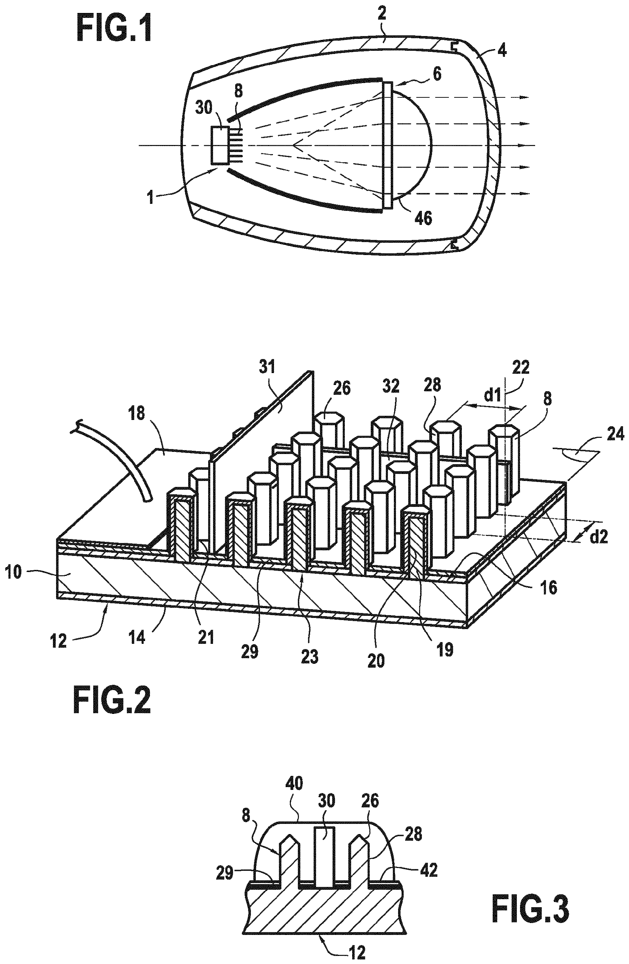

Sur la figure 2, le substrat 10 présente une face inférieure 12, sur laquelle est rapportée une première électrode 14, et une face supérieure 16, en saillie de laquelle s'étendent les bâtonnets électroluminescents 8 et sur laquelle est rapportée une deuxième électrode 18. Différentes couches de matériaux sont superposées sur la face supérieure 16, notamment après la croissance des bâtonnets électroluminescents depuis le substrat ici obtenue par une approche ascendante. Parmi ces différentes couches, on peut trouver au moins une couche de matériau conducteur électriquement, afin de permettre l'alimentation électrique des bâtonnets. Cette couche est gravée de manière à relier tel ou tel bâtonnet entre eux, l'allumage de ces bâtonnets pouvant alors être commandé simultanément par un module de commande ici non représenté. On pourra prévoir qu'au moins deux bâtonnets électroluminescents ou au moins deux groupes de bâtonnets électroluminescents de la source de lumière à semi-conducteur 1 sont agencés pour être allumés de manière distincte par l'intermédiaire d'un système de contrôle de l'allumage.

Les bâtonnets électroluminescents de dimensions submillimétriques s'étirent depuis le substrat et comportent, tel que cela est visible sur la figure 2, chacun un noyau 19 en nitrure de gallium, autour duquel sont disposés des puits quantiques 20 formés par une superposition radiale de couches de matériaux différents, ici du nitrure de gallium et du nitrure de gallium-indium, et une coque 21 entourant les puits quantiques également réalisé en nitrure de gallium.

Chaque bâtonnet s'étend selon un axe longitudinal 22 définissant sa hauteur, la base 23 de chaque bâtonnet étant disposée dans un plan 24 de la face supérieure 16 du substrat 10.

Les bâtonnets électroluminescents 8 de la source de lumière à semi-conducteur présentent avantageusement la même forme. Ces bâtonnets sont chacun délimités par une face terminale 26 et par une paroi circonférentielle 28 qui s'étend le long de l'axe longitudinal. Lorsque les bâtonnets électroluminescents sont dopés et font l'objet d'une polarisation, la lumière résultante en sortie de la source à semi-conducteur est émise principalement à partir de la paroi circonférentielle 28, étant entendu que l'on peut prévoir que de des rayons lumineux sortent également, au moins en petite quantité, à partir de la face terminale 26. Il en résulte que chaque bâtonnet agit comme une unique diode électroluminescente et que la densité des bâtonnets électroluminescents 8 améliore le rendement lumineux de cette source à semi-conducteur.

La paroi circonférentielle 28 d'un bâtonnet 8, correspondant à la coquille de nitrure de gallium, est recouverte par une couche d'oxyde conducteur transparent (OCT) 29 qui forme l'anode de chaque bâtonnet complémentaire à la cathode formée par le substrat. Cette paroi circonférentielle 28 s'étend le long de l'axe longitudinal 22 depuis le substrat 10 jusqu'à la face terminale 26, la distance de la face terminale 26 à la face supérieure 16 du substrat, depuis laquelle prennent naissance les bâtonnets électroluminescents 8, définissant la hauteur de chaque bâtonnet. A titre d'exemple, on prévoit que la hauteur d'un bâtonnet électroluminescent 8 est comprise entre 1 et 10 micromètres, tandis que l'on prévoit que la plus grande dimension transversale de la face terminale, perpendiculairement à l'axe longitudinal 22 du bâtonnet électroluminescent concerné, soit inférieure à 2 micromètres. On pourra également prévoir de définir la surface d'un bâtonnet, dans un plan de coupe perpendiculaire à cet axe longitudinal 22, dans une plage de valeurs déterminées, et notamment entre 1.96 et 4 micromètres carré.

On comprend que lors de la formation des bâtonnets 8, la hauteur peut être modifiée d'une source de lumière à l'autre, de manière à accroitre la luminance de la source de lumière à semi-conducteur lorsque la hauteur est augmentée. La hauteur des bâtonnets peut également être modifiée au sein d'une unique source de lumière, de sorte qu'un groupe de bâtonnets peut avoir une hauteur, ou des hauteurs, différentes d'un autre groupe de bâtonnets, ces deux groupes étant constitutifs de la source de lumière à semi-conducteur comprenant des bâtonnets électroluminescents de dimensions submillimétriques.

La forme des bâtonnets électroluminescents 8 peut également varier d'un dispositif à l'autre, notamment sur la section des bâtonnets et sur la forme de la face terminale 26. Il a été illustré sur la figure 2 des bâtonnets électroluminescents présentant une forme générale cylindrique, et notamment de section polygonale, ici plus particulièrement hexagonale. On comprend qu'il importe que de la lumière puisse être émise à travers la paroi circonférentielle, que celle-ci présente une forme polygonale ou circulaire par exemple.

Par ailleurs, la face terminale 26 peut présenter une forme sensiblement plane et perpendiculaire à la paroi circonférentielle, de sorte qu'elle s'étend sensiblement parallèlement à la face supérieure 16 du substrat 10, tel que cela est illustré sur la figure 2, ou bien elle peut présenter une forme bombée ou en pointe en son centre, de manière à multiplier les directions d'émission de la lumière sortant de cette face terminale, tel que cela est illustré sur la figure 3.

Sur la figure 2, les bâtonnets électroluminescents 8 sont agencés en matrice à deux dimensions, avec des bâtonnets alignés en rangées et en colonnes perpendiculaires les unes par rapport aux autres. Cet agencement pourrait être tel que les bâtonnets électroluminescents soient agencés en quinconce. L'invention couvre d'autres répartitions des bâtonnets, avec notamment des densités de bâtonnets qui peuvent être variables d'une source de lumière à l'autre, et qui peuvent être variables selon différentes zones d'une même source de lumière. On a représenté sur la figure 2 la distance de séparation d1 de deux bâtonnets électroluminescents immédiatement adjacents dans une première direction transversale et la distance de séparation d2 de deux bâtonnets électroluminescents immédiatement adjacentes dans une deuxième direction transversale. Les distances de séparation d1 et d2 sont mesurées entre deux axes longitudinaux 22 de bâtonnets électroluminescents adjacents. Le nombre de bâtonnets électroluminescents 8 s'étendant en saillie du substrat 10 peut varier d'un dispositif à l'autre, notamment pour augmenter la densité lumineuse de la source de lumière, mais on convient que l'une ou l'autre des distances de séparation dl, d2 doit être au minimum égale à 2 micromètres, afin que la lumière émise par la paroi circonférentielle 28 de chaque bâtonnet électroluminescent 8 puisse sortir de la matrice de bâtonnets. Par ailleurs, on prévoit que ces distances de séparation ne soient pas supérieures à 100 micromètres.

Le substrat 10 porte également des parois de séparation 30, qui consistent en des murets opaque agencés entre les bâtonnets pour définir une séparation physique de certains des bâtonnets les uns par rapport aux autres. On comprend que les bâtonnets peuvent ainsi être répartis en groupe d'une part par la commande d'alimentation sélective de chacun des bâtonnets, et d'autre part par des parois délimitant physiquement des zones d'implantation des bâtonnets et bloquant au moins partiellement les rayons émis par tel ou tel groupe de bâtonnets.

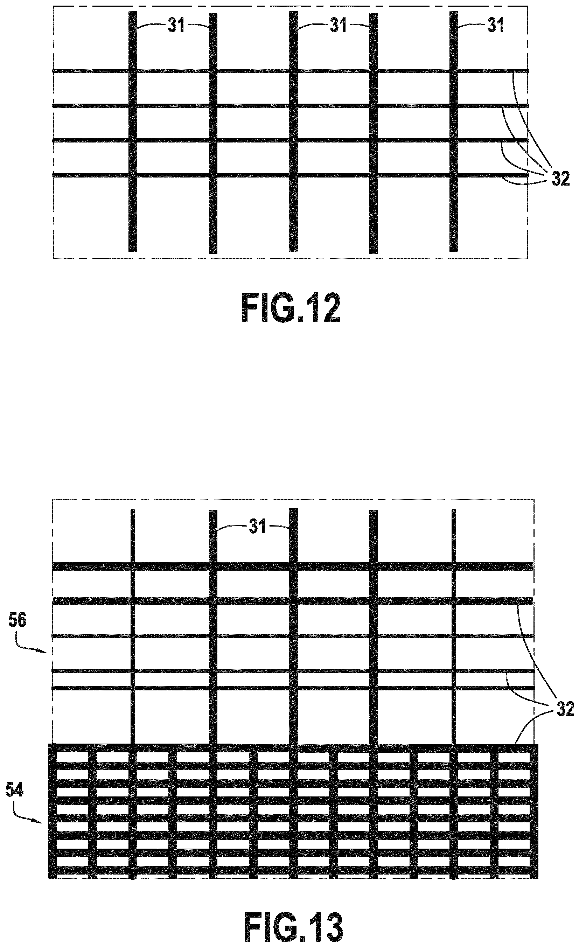

Une pluralité de parois de séparation 30 est prévue en saillie du substrat 10, et leur agencement sur celui-ci est variable d'une source de lumière à une autre relativement aux fonctions d'éclairage que l'on souhaite opérer avec le dispositif d'éclairage et/ou de signalisation associé à cette source de lumière. On décrira ci-après, notamment en rapport avec les figures 12 et 13, certains cas pratiques d'agencement des parois et les conséquences sur le faisceau émis par le dispositif associé. Le rôle de ces parois de séparation 30 est de former une coupure du faisceau lumineux émis par les rayons lumineux en sortie d'un ou plusieurs bâtonnets directement adjacent(s) à ces parois de séparation.

Notamment dans une source de lumière 1 dans laquelle les bâtonnets électroluminescents 8 sont agencés en matrice à lignes et colonnes (visible sur la figure 2), les parois de séparation 30 sont des murets qui s'étendent sensiblement rectilignement entre les rangées de bâtonnets. Des premières parois 31 peuvent s'étendre dans ce cas selon une première direction et des deuxièmes parois 32 peuvent s'étendre selon une deuxième direction, sensiblement perpendiculaire à la première direction. Dans l'exemple illustré sur la figure 2, afin de laisser visible les bâtonnets, on a représenté une première paroi 31 et une deuxième paroi 32, étant entendu que la source peut comporter avantageusement, en saillie du substrat 10, une pluralité de premières parois de séparation 31, sensiblement parallèles entre elle selon la première direction, et une pluralité de deuxièmes parois de séparation 32, sensiblement parallèles entre elles selon la deuxième direction.

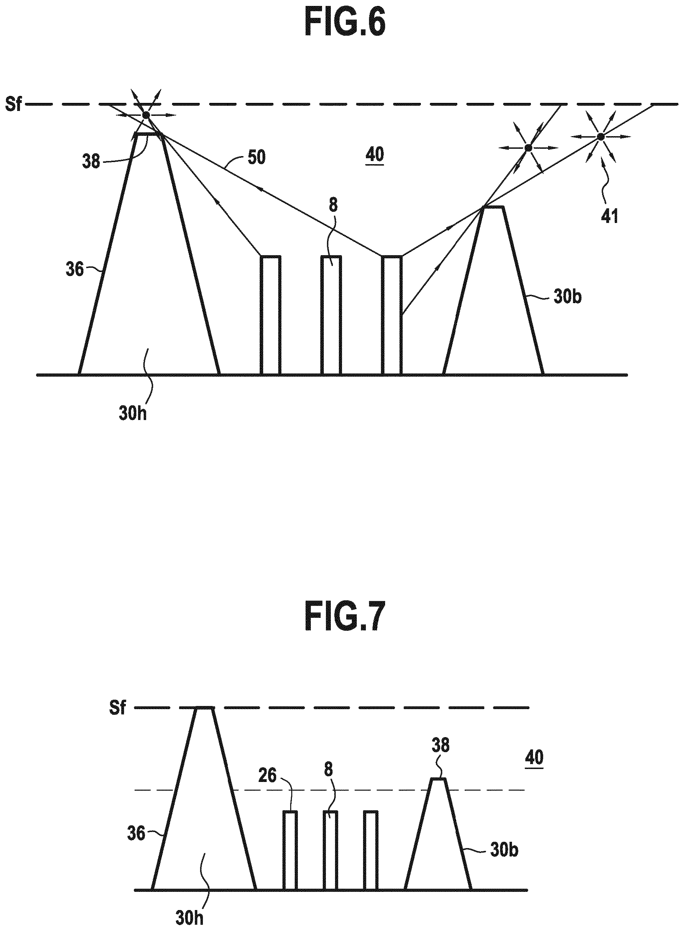

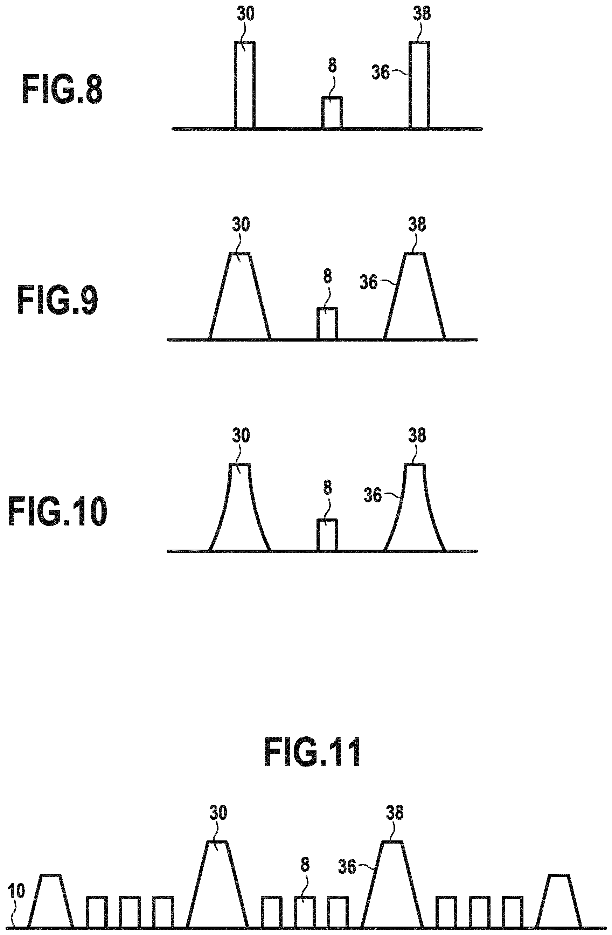

On comprend que l'écartement entre les parois de séparation successives d'une même série peut être constant, avec un nombre défini de rangées de bâtonnets 8 disposées entre ces deux parois successives 30, ou bien être différent le long de la série, selon la taille des groupes de bâtonnets que l'on souhaite former et les fonctions d'éclairage correspondantes. Plusieurs cas pratiques sont illustrés, avec notamment trois rangées de bâtonnets 8 disposées entre deux parois de séparation 30 successives (figure 6 et figure 7 par exemple, ou encore figure 11), ou encore une unique rangée de bâtonnets 8 disposée entre deux parois de séparation successives (figures 8 à 10 par exemple).

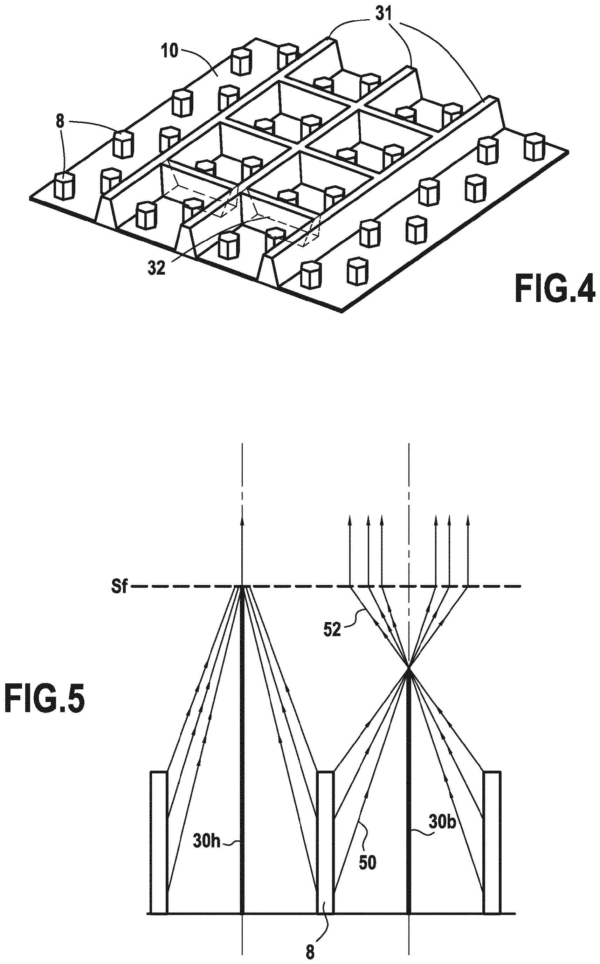

Chaque paroi de séparation 30 comporte des faces latérales 36, qui s'étendent en regard d'un ou plusieurs bâtonnets 8 peuvent prendre plusieurs formes distinctes, et une face supérieure 38, à l'extrémité libre de la paroi opposée au substrat. On comprend que les parois de séparation illustrées sur la figure 5 sous la forme de bâtonnets ne sont que des réalisations théoriques et qu'elles doivent dans la pratique présenter une épaisseur minimale, leur épaisseur maximale étant par ailleurs définie par l'écart entre deux bâtonnets qu'une telle paroi sépare.

Les parois de séparation consistent en des murets en saillie du substrat dont au moins une des faces latérales 36 peut permettre l'absorption ou la réflexion des rayons lumineux émis par les bâtonnets du groupe que les parois de séparation participent à définir en les entourant au moins partiellement. Selon l'un ou l'autre des cas d'absorption ou de réflexion, les parois de séparation pourront être formés par de la résine ou en métal, et présenter ou non sur la face latérale 36 un revêtement soit réfléchissant, soit diffusant, soit absorbant.

Selon différentes variantes de réalisation, les faces latérales 36 peuvent présenter une forme droite, sensiblement perpendiculaire au substrat, de sorte que la paroi de séparation présente la forme d'un muret rectiligne de section sensiblement rectangulaire, tel qu'illustré sur la figure 8, ou bien les faces latérales peuvent présenter une forme droite, incliné par rapport à la normale au substrat, de sorte que la paroi de séparation correspondante présente la forme d'un muret de section sensiblement trapézoïdale, tel qu'illustré sur la figure 9, ou bien encore les faces latérales peuvent présenter un profil en forme de parabole, tel qu'illustré sur la figure 10. Dans chacun de ces cas, la face supérieure 38 est sensiblement parallèle à la face supérieure 16 du substrat 10.

On décrira par la suite la caractéristique selon laquelle les hauteurs des parois de séparation peuvent être variables d'une paroi à l'autre, et en quoi cette hauteur variable joue un rôle sur la définition des lignes de coupure dans le faisceau émis en sortie du dispositif d'éclairage et/ou de signalisation.

La source de lumière 1 peut comporter en outre, tel qu'illustré notamment sur la figure 3, une couche 40 d'un matériau polymère formant un encapsulant dans laquelle des bâtonnets électroluminescents 8 et des parois de séparation 30 sont au moins partiellement noyés. La couche 40 peut ainsi s'étendre sur toute l'étendue du substrat ou seulement autour d'un groupe déterminé de bâtonnets électroluminescents 8. Le matériau polymère, qui peut notamment être à base de silicone, permet de protéger les bâtonnets électroluminescents 8 sans gêner la diffusion des rayons lumineux. En outre, il est possible d'intégrer dans cette couche 40 de matériau polymère des moyens de conversion de longueur d'onde, et par exemple des luminophores 41, aptes à absorber au moins une partie des rayons émis par l'un des bâtonnets et à convertir au moins une partie de ladite lumière d'excitation absorbée en une lumière d'émission ayant une longueur d'onde différente de celle de la lumière d'excitation. On pourra prévoir indifféremment que les moyens de conversion de longueur d'onde sont noyés dans la masse du matériau polymère, ou bien qu'ils sont disposés en surface de la couche de ce matériau polymère.

La source de lumière peut comporter en outre un revêtement 42 de matériau réfléchissant la lumière qui est disposé entre les bâtonnets électroluminescents 8 pour dévier les rayons, initialement orientés vers le substrat, vers la face terminale 26 des bâtonnets électroluminescents 8. En d'autres termes, la face supérieure 16 du substrat 10 peut comporter un moyen réfléchissant qui renvoie les rayons lumineux, initialement orientés vers la face supérieure 16, vers la face de sortie de la source de lumière. On récupère ainsi des rayons qui autrement seraient perdus. Ce revêtement 42 est disposé entre les bâtonnets électroluminescents 8 sur la couche d'oxyde conducteur transparent 29.

La source de lumière 1 comporte ici une forme rectangulaire, mais on comprendra qu'elle peut présenter sans sortir du contexte de l'invention d'autres formes générales, et notamment une forme de parallélogramme.

L'optique de mise en forme 6 peut notamment comprendre une lentille 46 qui dévie les rayons émis par la source de lumière disposée au foyer objet de la lentille pour former un faisceau réglementaire, c'est-à-dire qui respecte la grille photométrique de tel ou tel faisceau d'éclairage, et par exemple un feu de croisement, un feu de route, un feu diurne.

Sur la source de lumière, un groupe de bâtonnets est défini par sa disposition entre au moins deux parois de séparation 30, les dimensions de ce groupe pouvant en outre être définies par des bords du substrat composant la source de lumière. Chaque groupe est configuré pour émettre des rayons dont l'émission par l'optique de mise en forme crée une portion du faisceau global. Lorsque les bâtonnets de ce groupe sont éteints, une zone sombre est réalisée dans le faisceau projeté et l'on recherche, selon l'emplacement de cette zone sombre dans le faisceau, une coupure plus ou moins nette.

Selon l'invention, au moins deux parois de séparation 30 définissant un même groupe de bâtonnets 8 présentent une hauteur différente l'une de l'autre. Dans des modes de réalisation illustrés sur les figures 2 et 4, ce sont au moins une première paroi de séparation 31 et une deuxième paroi de séparation 32, c'est-à-dire des parois de séparation dont les première et deuxième directions d'allongement sont sécantes, qui présentent des hauteurs différentes. Et dans des modes de réalisation illustrés sur les figures 5 à 7, et notamment sur la figure 11, ce sont des parois de séparation successives d'une même série qui présentent des hauteurs différentes. L'effet technique de ces différentes hauteurs de parois de séparation définissant un même groupe de bâtonnets est de permettre des nettetés de coupure différentes.

En effet, la netteté de la coupure de la portion de faisceau crée par les rayons émis par le groupe de bâtonnets entourés de parois de séparation dépend de la hauteur de ces parois de séparation et de la proximité de la face d'extrémité de cette paroi avec la surface focale objet de l'optique de mise en forme. Plus la paroi de séparation est proche de cette surface focale, plus la coupure correspondante est nette.

Ceci est décrit en s'appuyant sur l'illustration de la figure 5, dans laquelle il est notable que les parois de séparation sont représentées théoriquement avec un trait.

Une paroi de séparation « haute » 30h présente une extrémité libre 38 sensiblement confondue avec la surface focale Sf de l'optique de mise en forme du dispositif d'éclairage et/ou de signalisation, tandis qu'une paroi de séparation « basse » 30b présente une extrémité libre disposée en retrait de cette surface focale Sf, c'est-à-dire qu'elle s'étend entre la surface focale Sf et la face supérieure du substrat.

Un premier bâtonnet 8 émet des premiers rayons 50 (représenté par des trais à simple flèche) depuis sa paroi circonférentielle 28, sur toute la hauteur de celle-ci. On comprendra que les rayons peuvent partir dans n'importe quelle direction, et qu'il n'a été représenté que six premiers rayons 50 partant à l'opposé du substrat pour clarifier la lecture de la figure.

D'un côté, les premiers rayons sont bloqués par une paroi de séparation « haute » et de l'autre, les rayons sont bloqués par une paroi de séparation « basse ». On comprend que les premiers rayons 50 qui sont orientés pour passer au-delà de la paroi de séparation haute croisent préalablement la surface focale Sf et restent ainsi dans le segment lumineux défini pour ce premier bâtonnet entre les parois de séparation. Il en est de même pour le bâtonnet voisin disposé de l'autre côté de la paroi de séparation « haute », de sorte que la coupure entre les premiers rayons 50 et les deuxièmes rayons 52 (représentés par des traits à double flèche) est nette.

De l'autre côté, les premiers rayons 50 sont bloqués par une paroi de séparation « basse », c'est-à-dire en retrait de la surface focale, et dès lors les rayons émis par les bâtonnets coupent la surface focale au-delà de l'espace défini par les parois de séparation autour du groupe de bâtonnets. Tel que cela est illustré, il en résulte des premiers rayons 50 émis par le premier bâtonnet qui débordent dans le segment lumineux associé au bâtonnet voisin, et de façon analogue, des seconds rayons 52 émis par un bâtonnet voisin débordent dans le segment lumineux associé au premier bâtonnet (et représenté par les traits pointillés). La coupure entre les segments est ainsi rendue floue.

Ainsi, en faisant varier la hauteur des parois de séparation, on crée une défocalisation, c'est-à-dire une variation de la distance entre la face d'extrémité libre, ou face supérieure, de la paroi de séparation et la surface focale de l'optique de mise en forme.

Tel qu'illustré sur cette figure 5, la surface focale Sf de l'optique de mise en forme 6 est ajustée sur la face d'extrémité libre 38 de la paroi de séparation 30 qui s'étend le plus haut, c'est-à-dire le plus à distance du substrat 10. Cette paroi de séparation participe alors à former une coupure nette entre les faisceaux créés par les groupes de bâtonnets qu'elle sépare. La paroi de séparation qui présente une hauteur différente, et dont la face d'extrémité libre s'étend donc à distance de la surface focale de l'optique de mise en forme, participe à la formation d'une coupure floue.

Tel que cela a été décrit, une couche 40 d'un matériau polymère est avantageusement disposée sur le substrat pour former un encapsulant dans laquelle des bâtonnets électroluminescents 8 et des parois de séparation 30 sont au moins partiellement noyés, et cette couche de matériau polymère comprend des moyens de conversion de longueur d'onde, et par exemple des luminophores 41, aptes à absorber au moins une partie des rayons émis par l'un des bâtonnets et à convertir au moins une partie de ladite lumière d'excitation absorbée en une lumière d'émission ayant une longueur d'onde différente de celle de la lumière d'excitation. Cet encapsulant doit s'étendre en hauteur au moins au-dessus des bâtonnets, pour les protéger, et on pourra prévoir selon des variantes de réalisation qu'il ne recouvre pas entièrement les parois de séparation (figure 7) ou au contraire qu'il est prévu suffisamment haut, c'est-à-dire à distance du substrat, pour recouvrir entièrement les parois de séparation (figure 6) et que dès lors la surface focale de l'optique de mise en forme peut être ajusté sur la surface supérieure de l'encapsulant, c'est-à-dire la surface à l'opposé du substrat. Dans ce dernier cas, il convient de noter que les rayons passant au-delà d'une paroi de séparation « basse » 30b subissent une diffusion par les grains de phosphore formant luminophore 41 sur une zone plus haute, ou épaisse, ce qui génère un flou plus important des rayons.

Dans les différentes figures décrites jusque-là, il n'a été fait mention que de parois de séparation 30 parallèles. Il est intéressant de noter que dans ce contexte, tel qu'illustré sur la figure 11, la hauteur des parois de séparation évolue en diminuant depuis le centre de la source de lumière vers les bords. On obtient ainsi des coupures nettes dans l'axe de circulation et des coupures plus floues sur les côtés du champ de vision.

Toutefois, tel que cela a pu être précisé précédemment, il est désormais nécessaire de prévoir la netteté de coupures dans un même faisceau aussi bien verticales qu'horizontales. Ceci est rendu possible selon l'invention par la réalisation de parois de séparation sécantes qui présentent des hauteurs différentes.

On va maintenant décrire deux agencements particuliers de parois de séparation 30 en saillie d'un substrat 10, dans lequel au moins deux parois, conformément à l'invention, présentent des hauteurs différentes.

Sur la figure 12, on a illustré un agencement simple, dans lequel une première série de premières parois de séparation 31 s'étend verticalement et dans lequel une deuxième série de deuxièmes parois de séparation 32 s'étend horizontalement. Les premières parois formant des murs verticaux ont une hauteur plus importante que la hauteur des deuxièmes parois formant des murs horizontaux, de sorte qu'on génère des coupures nettes entre des segments verticaux, afin notamment de permettre la réalisation d'un faisceau matriciel dans lequel des bandes sombres peuvent être crées sans diminuer l'intensité lumineuse de chaque côté de ces bandes sombres, et de sorte qu'on génère des coupures moins nettes entre des bandes horizontales. On sait ainsi répondre aux exigences d'un faisceau de type ADB (acronyme anglais pour « Adaptive Driving Beam ») ou de type Code par exemple.

Sur la figure 13, on a illustré un agencement plus complexe, que l'invention permet sans difficulté majeure de réalisation, la croissance des parois de séparation sur le substrat étant facilement réalisable et techniquement aussi simple que la croissance des bâtonnets sur le substrat. Le faisceau présente ici une partie basse 54 et une partie haute 56, distinctes notamment en ce que dans la partie basse 54, les parois de séparation sont toutes hautes, c'est-à-dire que leur face d'extrémité est sensiblement disposée sur la surface focale de l'optique de mise en forme. Cette partie basse 54 du faisceau présente donc des zones aux coupures relativement nettes et une image qui en résulte très pixellisée, de sorte que cette partie peut être associée par exemple à du marquage au sol.

La partie haute 56 du faisceau comporte des parois de séparation de hauteur différente, avec une série de premières parois 31 verticales dont la hauteur varie depuis le centre vers les bords de la source de lumière, c'est-à-dire que les premières parois 31 verticales les plus hautes sont au centre de la source de lumière. On permet ainsi des coupures de plus en plus floues vers l'extérieur du champ de vision.

Par contre dans cette partie haute, les deuxièmes parois 32 horizontales sont telles qu'elles présentent, au voisinage de la partie basse 54, une hauteur moindre que celle des premières parois, et moindre que celles des deuxièmes parois de la partie basse, et notamment de sorte que leur face d'extrémité est en retrait de la surface focale de l'optique de mise en forme, c'est-à-dire entre cette surface focale et le support depuis lequel les parois s'étendent. On vise ainsi à rendre plus floues les coupures, ce qui est notamment utile pour la fonction « feux de croisement », au centre du champ de vision du conducteur. Par ailleurs, dans une partie d'extrémité supérieure de la partie haute du faisceau, les deuxièmes parois 32 horizontales peuvent reprendre une hauteur plus importante.

La présente invention s'applique aussi bien à un projecteur avant qu'à un feu arrière de véhicule automobile. La description qui précède explique clairement comment l'invention permet d'atteindre les objectifs qu'elle s'est fixés et notamment de proposer un dispositif d'éclairage et/ou de signalisation qui permette d'obtenir, par application de parois de séparation à hauteurs variables dans une source à semi-conducteur entre les différents émetteurs de lumière, une meilleure gestion des coupures entre les portions de faisceau émis, avec la possibilité de jouer sur la netteté de ces coupures selon leur position dans le faisceau, afin de proposer des coupures très nettes dans des zones du faisceau où un éclairage sélectif, c'est-à-dire un éclairage dans lequel on sait rendre sombre une partie du faisceau pour ne pas éblouir d'autres usagers par exemple, est souhaité et d'autre part des coupures floues notamment à la périphérie du faisceau. Tel que cela a pu être précisé précédemment, on saura appliquer la présence de parois de séparation entre des éléments émetteurs de lumière aussi bien sur un substrat avec des éléments émetteurs formés de bâtonnets électroluminescents qu'avec d'autres types d'élément émetteurs de lumière s'étendant en saillie d'un support, dès lors que la hauteur des parois de séparation est configurée selon le principe de l'invention, c'est-à-dire de sorte qu'au moins deux parois de séparation définissant un même groupe d'émetteurs présentent une hauteur différente.

## Revendications

1. Source de lumière (1) à semi-conducteur comprenant une pluralité d'émetteurs de lumière (8) agencés en surface d'un support (10) ainsi qu'une pluralité de parois de séparation (30,31,32) s'étendant également depuis le support en étant agencées entre lesdits émetteurs de manière à définir des groupes d'émetteurs et de telle sorte qu'au moins deux parois de séparation définissant un même groupe d'émetteurs présentent une hauteur différente **caractérisée en ce qu'**au moins une paroi de séparation (30,31,32) présente une section sensiblement trapézoïdale.

2. Source de lumière (1) selon la revendication 1, comprenant un substrat (10), une pluralité de bâtonnets électroluminescents (8) à semi-conducteur s'étendant respectivement depuis le substrat, ainsi qu'une pluralité de parois de séparation (30,31,32) s'étendant également depuis le substrat en étant agencées entre lesdits bâtonnets de manière à définir des groupes de bâtonnets et de telle sorte qu'au moins deux parois de séparation présentent une hauteur différente.

3. Source de lumière selon la revendication 1, **caractérisée en ce que** lesdites deux parois de séparation (30,31,32) de hauteur différente s'étendent sensiblement perpendiculairement l'une par rapport à l'autre.

4. Source de lumière selon l'une des revendications 1 ou 2, **caractérisée en ce qu'**une première série de premières parois de séparation (31), sensiblement parallèles entre elles, s'étend depuis le substrat selon une première direction, en présentant une hauteur moyenne supérieure à la hauteur moyenne d'une deuxième série de deuxièmes parois de séparation (32), sensiblement parallèles entre elles et s'étendant selon une deuxième direction sensiblement perpendiculairement à la première direction.

5. Source de lumière selon la revendication 3, **caractérisée en ce qu'**au moins les premières parois de séparation (31) de la première série présentent une hauteur évolutive, allant en décroissant du centre de la source de lumière (1) vers au moins un bord de la source de lumière.

6. Source de lumière selon l'une des revendications précédentes, **caractérisée en ce qu'**au moins certains des bâtonnets électroluminescents (8) sont activables sélectivement.

7. Source de lumière selon l'une des revendications 2 à 6, **caractérisée en ce qu'**une couche d'un matériau (40) formant un encapsulant est déposé sur le substrat (10) en recouvrement au moins partiel des bâtonnets (8) et des parois de séparation (30), ledit encapsulant s'étendant au moins jusqu'à recouvrir le bâtonnet le plus haut.

8. Source de lumière selon la revendication précédente, **caractérisée en ce que** l'encapsulant contient un luminophore (41).

9. Dispositif lumineux comprenant une source de lumière (1) selon l'une des revendications précédentes et une optique de mise en forme (6) des rayons lumineux émis par cette source de lumière.

10. Dispositif lumineux selon la revendication précédente, **caractérisé en ce que** la hauteur différente d'au moins deux parois de séparation (30,31,32) permet d'obtenir un faisceau lumineux présentant des coupures à netteté variable.

11. Dispositif lumineux selon l'une des revendications 9 ou 10, lorsque la source de lumière (1) dépend d'au moins la revendication 3, **caractérisé en ce que** la première série de premières parois de séparation (31) s'étend sensiblement verticalement en regard de l'optique de mise en forme tandis que la deuxième série de deuxièmes parois de séparation (32) s'étend sensiblement horizontalement en regard de l'optique de mise en forme.

12. Dispositif lumineux selon l'une des revendications 9 à 11, lorsque la source de lumière (1) dépend d'au moins la revendication 7, 8, **caractérisé en ce que** l'encapsulant recouvre l'intégralité des parois de séparation (30,31,32), la surface focale (Sf) de l'optique de mise en forme (6) étant sensiblement ajustée sur la surface d'extrémité de l'encapsulant à l'opposé du substrat (10).

13. Dispositif lumineux selon l'une des revendications 9 à 11, lorsque la source de lumière (1) dépend d'au moins la revendication 7, **caractérisé en ce que** l'encapsulant recouvre partiellement une ou plusieurs parois de séparation (30,31,32), la surface focale (Sf) de l'optique de mise en forme (6) étant ajustée sur la face d'extrémité (38) de la paroi de séparation (30,31,32) la plus haute.

14. Dispositif lumineux selon l'une des revendications 9 à 13, **caractérisé en ce que** la source de lumière (1) à semi-conducteur assure la génération de rayons de lumière qui forment au moins une partie d'un faisceau lumineux réglementaire pour véhicule automobile.

15. Dispositif lumineux selon l'une des revendications 9 à 14, **caractérisé en ce que** l'optique de mise en forme comporte une optique de projection.

## Patentansprüche

1. Halbleiter-Lichtquelle (1) mit einer Vielzahl von Lichtemittern (8), die auf der Oberfläche eines Trägers (10) angeordnet sind, und einer Vielzahl von Trennwänden (30, 31, 32), die sich ebenfalls von dem Träger erstrecken und zwischen den Emittern angeordnet sind, um Emittergruppen zu definieren und so, daß mindestens zwei Trennwände, die die gleiche Emittergruppe definieren, eine unterschiedliche Höhe haben, **dadurch gekennzeichnet, daß** mindestens eine Trennwand (30, 31, 32) einen im wesentlichen trapezförmigen Querschnitt hat.

2. Lichtquelle (1) nach Anspruch 1, umfassend ein Substrat (10), eine Vielzahl von lichtemittierenden Halbleiterstäben (8), die sich jeweils von dem Substrat aus erstrecken, und eine Vielzahl von Trennwänden (30, 31, 32), die sich ebenfalls von dem Substrat aus erstrecken und zwischen den Stäben so angeordnet sind, dass sie Gruppen von Stäben definieren, und so, dass mindestens zwei Trennwände eine unterschiedliche Höhe haben.

3. Lichtquelle nach Anspruch 1, **dadurch gekennzeichnet, daß** sich die beiden Trennwände (30, 31, 32) unterschiedlicher Höhe im wesentlichen senkrecht zueinander erstrecken.

4. Lichtquelle nach einem der Ansprüche 1 oder 2, **dadurch gekennzeichnet, daß** eine erste Reihe von ersten Trennwänden (31), die im wesentlichen parallel zueinander sind, sich von dem Substrat in einer ersten Richtung erstreckt, die eine mittlere Höhe aufweist, die größer ist als die mittlere Höhe einer zweiten Reihe von zweiten Trennwänden (32), die im wesentlichen parallel zueinander sind und sich in einer zweiten Richtung im wesentlichen senkrecht zu der ersten Richtung erstrecken.

5. Lichtquelle nach Anspruch 3, **dadurch gekennzeichnet, dass** zumindest die ersten Trennwände (31) der ersten Serie eine evolutionäre Höhe aufweisen, die von der Mitte der Lichtquelle (1) zu mindestens einem Rand der Lichtquelle hin abnimmt.

6. Lichtquelle nach einem der vorstehenden Ansprüche, **dadurch gekennzeichnet, dass** mindestens einige der lichtemittierenden Stäbe (8) selektiv aktivierbar sind.

7. Lichtquelle nach einem der Ansprüche 2 bis 6, **dadurch gekennzeichnet, dass** eine Schicht aus einem Material (40), das eine Einkapselung bildet, auf dem Substrat (10) abgeschieden ist, die zumindest teilweise die Stäbe (8) und Trennwände (30) bedeckt, wobei sich die Einkapselung zumindest bis zur Abdeckung des obersten Stabes erstreckt.

8. Lichtquelle nach dem vorstehenden Anspruch, **dadurch gekennzeichnet, dass** die Verkapselung einen Leuchtstoff (41) enthält.

9. Leuchtvorrichtung mit einer Lichtquelle (1) nach einem der vorstehenden Ansprüche und einem optischen System (6) zur Formung der von dieser Lichtquelle emittierten Lichtstrahlen.

10. Leuchtvorrichtung nach dem vorhergehenden Anspruch, **dadurch gekennzeichnet, dass** die unterschiedliche Höhe von mindestens zwei Trennwänden (30, 31, 32) es ermöglicht, einen Lichtstrahl mit variablen Schärfeeinschnitten zu erhalten.

11. Leuchtvorrichtung nach einem der Ansprüche 9 oder 10, wenn die Lichtquelle (1) von mindestens Anspruch 3 abhängig ist, **dadurch gekennzeichnet, dass** sich die erste Reihe von ersten Trennwänden (31) im Wesentlichen vertikal gegenüber der formgebenden Optik erstreckt, während sich die zweite Reihe von zweiten Trennwänden (32) im Wesentlichen horizontal gegenüber der formgebenden Optik erstreckt.

12. Lichtvorrichtung nach einem der Ansprüche 9 bis 11, wenn die Lichtquelle (1) von mindestens Anspruch 8 abhängig ist, **dadurch gekennzeichnet, dass** die Verkapselung die gesamten Trennwände (30, 31, 32) bedeckt, wobei die Brennfläche (Sf) der formgebenden Optik (6) im Wesentlichen auf die dem Substrat (10) gegenüberliegende Endfläche der Verkapselung eingestellt ist.

13. Leuchtvorrichtung nach einem der Ansprüche 9 bis 11, wobei die Lichtquelle (1) von mindestens Anspruch 8 abhängt, **dadurch gekennzeichnet, dass** die Einkapselung eine oder mehrere Trennwände (30, 31, 32) teilweise bedeckt, wobei der Brennpunkt (Sf) der formgebenden Optik (6) an der Stirnfläche (38) der obersten Trennwand (30, 31, 32) angebracht ist.

14. Leuchtvorrichtung nach einem der Ansprüche 9 bis 13, **dadurch gekennzeichnet, dass** die Halbleiter-Lichtquelle (1) Lichtstrahlen erzeugt, die zumindest einen Teil eines Regellichtbündels für Kraftfahrzeuge bilden.

15. Leuchtvorrichtung nach einem der Ansprüche 9 bis 14, **dadurch gekennzeichnet, dass** die formgebende Optik eine Projektionsoptik umfasst.

## Claims

1. A semiconductor light source (1) comprising a plurality of light emitters (8) arranged on the surface of a carrier (10) and a plurality of partition walls (30, 31, 32) also extending from the carrier and being arranged between said emitters so as to define emitter groups and such that at least two partition walls defining the same emitter group have a different height **characterised in that** at least one partition wall (30, 31, 32) has a substantially trapezoidal cross-section.

2. A light source (1) according to claim 1, comprising a substrate (10), a plurality of semiconductor light-emitting rods (8) respectively extending from the substrate, and a plurality of partition walls (30, 31, 32) also extending from the substrate and being arranged between said rods so as to define groups of rods and such that at least two partition walls have a different height.

3. A light source according to claim 1, **characterized in that** said two partition walls (30, 31, 32) of different height extend substantially perpendicularly to each other.

4. A light source according to one of claims 1 or 2, **characterized in that** a first series of first partition walls (31), substantially parallel to each other, extends from the substrate in a first direction, having an average height greater than the average height of a second series of second partition walls (32), substantially parallel to each other and extending in a second direction substantially perpendicular to the first direction.

5. A light source according to claim 3, **characterized in that** at least the first partition walls (31) of the first series have an evolutionary height, decreasing from the center of the light source (1) towards at least one edge of the light source.

6. A light source according to one of the preceding claims, **characterized in that** at least some of the light-emitting rods (8) are selectively activatable.

7. A light source according to one of claims 2 to 6, **characterized in that** a layer of a material (40) forming an encapsulant is deposited on the substrate (10) at least partially covering the rods (8) and partition walls (30), said encapsulant extending at least to cover the uppermost rod.

8. A light source according to the preceding claim, **characterized in that** the encapsulant contains a phosphor (41).

9. Lighting device comprising a light source (1) according to one of the preceding claims and an optical system (6) for shaping the light rays emitted by this light source.

10. Lighting device according to the preceding claim, **characterized in that** the different height of at least two partition walls (30, 31, 32) makes it possible to obtain a light beam with variable sharpness cuts.

11. Lighting device according to one of claims 9 or 10, when the light source (1) depends on at least claim 3, **characterized in that** the first series of first partition walls (31) extends substantially vertically opposite the shaping optics, while the second series of second partition walls (32) extends substantially horizontally opposite the shaping optics.

12. Lighting according to one of claims 9 to 11, when the light source (1) is dependent on at least claim 8, **characterized in that** the encapsulant covers the entire partition walls (30, 31, 32), the focal surface (Sf) of the shaping optics (6) being substantially adjusted to the end surface of the encapsulant opposite the substrate (10).

13. Lighting device according to one of claims 9 to 11, where the light source (1) depends on at least claim 8, **characterised in that** the encapsulant partially covers one or more partition walls (30, 31, 32), the focal area (Sf) of the shaping optics (6) being fitted to the end face (38) of the uppermost partition wall (30, 31, 32).

14. Lighting device according to one of claims 9 to 13, **characterized in that** the semiconductor light source (1) generates light rays which form at least part of a regulation light beam for motor vehicles.

15. Lighting device according to one of claims 9 to 14, **characterized in that** the shaping optics comprise projection optics.
